# FASCICULE DE BREVET EUROPEEN

(11) **EP 0 998 183 B1**
(45) Date de publication et mention de la délivrance du brevet: **12.01.2005**
(21) Numéro de dépôt: 99402637.5
(22) Date de dépôt: 25.10.1999
(51) Int. Cl.: H05K 9/00, B64G 1/54

(54) **Dispositif à boitier comportant des hautes tensions, protégé contre des charges électriques mobiles et satellite équipé d'un tel dispositif**
Hochspannungs-Aufnahmevorrichtung, die gegen bewegliche elektrische Ladungen geschützt ist und Satellit mit einer solchen Vorrichtung
High voltage housing device protected against mobile electric charges and satellite provided with such a device

(30) Priorité: 29.10.1998 FR 9813581
(43) Date de publication de la demande: 03.05.2000
(73) Titulaire: ALCATEL, 75008 Paris (FR)
(72) Inventeur: Martineau, Patrick, 31700 Blagnac (FR); Berthelier, Jean-Jacques, 78140 Vélizy (FR)
(74) Mandataire: Lamoureux, Bernard

(56) Documents cités:
- US-A- 5 818 060

## Description

### DOMAINE TECHNIQUE

La présente invention concerne un dispositif comprenant :
- au moins un circuit de haute tension et
- un boîtier contenant ce circuit et comportant au moins une ouverture qui met l'intérieur du boîtier en communication avec l'extérieur de celui-ci, des charges électriques de signe contraire à celui de la haute tension étant susceptibles d'être présentes à l'extérieur du boîtier et de pénétrer dans ce boîtier.

L'invention s'applique notamment à tout satellite de télécommunications muni d'un tel dispositif.

### ÉTAT DE LA TECHNIQUE ANTÉRIEURE

Les amplificateurs à tubes à ondes progressives ou ATOPs (« travelling wave tube amplifiers » ou TWTAs), compris dans les charges utiles de télécommunications qui sont embarquées sur des satellites, ont récemment été sujets à des incidents de fonctionnement, voire à des pannes définitives, à la suite de la mise en route des moteurs ioniques qui sont utilisés pour le contrôle du positionnement des satellites.

### EXPOSÉ DE L'INVENTION

La présente invention vise à résoudre le problème précédent en s'opposant à toute entrée de plasma, engendré par ces moteurs ioniques, dans les boîtiers contenant les circuits d'alimentation des ATOPs, et à toute fuite de potentiel à l'extérieur de ces boîtiers, fuites qui favorisent l'entrée du plasma en attirant une partie de celui-ci au voisinage des hautes tensions présentes dans les ATOPs.

Plus généralement, l'invention vise à protéger un dispositif, du type mentionné plus haut, vis-à-vis des charges électriques susceptibles d'être présentes au voisinage de son boîtier.

De façon précise, la présente invention a pour objet un dispositif du type mentionné plus haut, caractérisé en ce qu'il comprend en outre :
- des moyens de protection qui n'obturent pas l'ouverture et sont prévus pour s'opposer
- à l'entrée de ces charges à l'intérieur du boîtier et
- à l'existence, à l'extérieur de ce dernier, de potentiels élevés dus à la haute tension du circuit.

Grâce à ces moyens de protection, on supprime les charges trop importantes, voire les courts-circuits, que le plasma peut engendrer au niveau des ATOPs d'un satellite de télécommunications.

Selon un mode de réalisation préféré du dispositif objet de l'invention, les moyens de protection comprennent une plaque électriquement conductrice fixée et reliée électriquement au boîtier, en regard de l'ouverture, à l'extérieur ou à l'intérieur de ce boîtier, et débordant sur la périphérie de cette ouverture.

Selon une variante de réalisation, les moyens de protection comprennent deux plaques électriquement conductrices fixées et reliées électriquement au boîtier, en regard de l'ouverture, respectivement à l'intérieur et à l'extérieur de ce boîtier, et débordant sur la périphérie de cette ouverture.

De préférence, la plaque, qui est située à l'intérieur du boîtier, est recouverte d'un matériau électriquement isolant du côté du circuit.

Selon un mode de réalisation préféré de l'invention, chaque plaque conductrice est un clinquant de faible épaisseur.

Au lieu d'une ou deux plaques, les moyens de protection peuvent comprendre une grille électriquement conductrice qui est fixée et reliée électriquement au boîtier et qui ferme l'ouverture.

Les charges électriques de signe contraire à celui de la haute tension proviennent par exemple d'un plasma.

Chaque circuit peut comprendre un ATOP ou être un circuit d'alimentation d'équipement embarqué comportant des tensions telles que le fonctionnement du circuit puisse être perturbé par la présence de plasma.

L'invention concerne aussi un satellite comprenant au moins un moteur ionique ou fonctionnant en présence de plasma naturel,
ce satellite étant caractérisé en ce qu'il comprend au moins un dispositif conforme à l'invention, les charges électriques :
- provenant du plasma engendré par le moteur ionique ou du plasma naturel
- ou étant créées artificiellement par un générateur.

### BRÈVE DESCRIPTION DES DESSINS

La présente invention sera mieux comprise à la lecture de la description d'exemples de réalisation donnés ci-après, à titre purement indicatif et nullement limitatif, en faisant référence aux dessins annexés sur lesquels :
- la figure 1 est une vue schématique d'un satellite muni d'un dispositif connu, comportant des hautes tensions, et d'un moteur ionique, et
- la figure 2 est une vue schématique d'un mode de réalisation particulier du dispositif objet de l'invention.

### EXPOSÉ DÉTAILLÉ DE MODES DE RÉALISATION PARTICULIERS

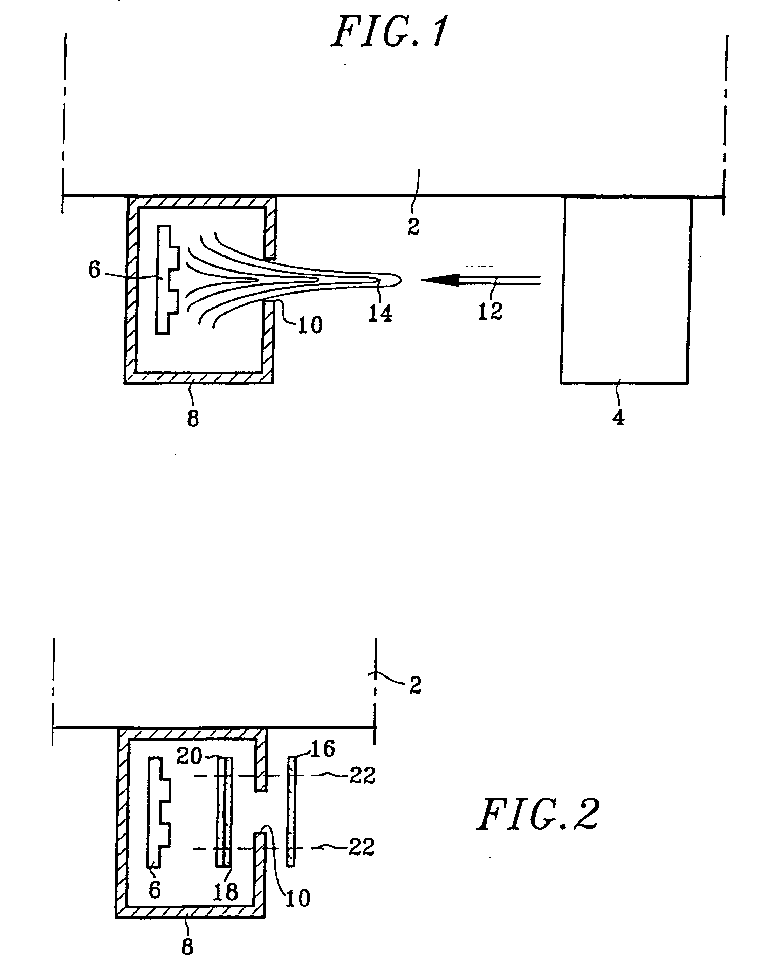

La figure 1 est une vue en coupe très schématique d'un satellite 2 muni d'un ou de plusieurs moteurs ioniques, tels que le moteur 4, et de moyens de télécommunications comprenant des ATOPs, moyens dont on a simplement représenté un dispositif connu, comprenant des circuits de haute tension 6 qui sont destinés à l'alimentation des ATOPs et sont disposés à l'intérieur d'un boîtier métallique 8.

Ce dernier comprend des évents tels que l'évent 10, permettant la mise en communication de l'intérieur avec l'extérieur du boîtier et facilitant donc le dégazage à l'intérieur de ce boîtier lorsque le satellite est dans l'espace.

Lorsque le moteur ionique 4 est actionné, il engendre un plasma dont une partie 12 se dirige vers le boîtier 8 et pénètre dans celui-ci par les évents.

De plus, des fuites de potentiel se produisent à travers ces évents et l'on a représenté sur la figure 1 les équipotentielles correspondantes 14.

Ces fuites augmentent considérablement le taux d'entrée du plasma en attirant les charges du plasma dont le signe est opposé à celui de la haute tension des circuits.

Conformément à l'invention, on résout ce problème en s'opposant à l'entrée du plasma par les évents ainsi qu'à la fuite de potentiel à travers ces derniers mais sans obturer ces évents.

La figure 2 est une vue en coupe très schématique d'un dispositif conforme à l'invention comprenant les circuits 6 de la figure 1, placés dans le boîtier 8, et en outre une plaque métallique de préférence très mince (pour des questions de poids), telle qu'un clinquant 16, qui est fixée et reliée électriquement au boîtier 8, à l'extérieur de celui-ci, en regard de chaque évent 10, et qui déborde sur la périphérie de cet évent.

En variante, on fixe et on relie électriquement un clinquant 18 au boîtier 8, à l'intérieur de celui-ci, en regard de chaque évent 10 et de façon que ce clinquant déborde sur la périphérie de l'évent correspondant et se trouve compris entre ce dernier et les circuits de haute tension.

De préférence, on recouvre la face du clinquant 18, située du côté des circuits 6, d'une couche électriquement isolante 20 afin d'éviter des claquages entre la haute tension et le clinquant.

Il est même possible d'utiliser le clinquant intérieur 16 et le clinquant extérieur 18 (muni de la couche isolante 20) en regard d'un même évent 10.

L'association d'un clinquant et de la paroi du boîtier située à la périphérie de l'évent correspondant à ce clinquant constitue une chicane qui s'oppose à l'entrée du plasma et ce, de façon d'autant plus efficace que le rapport entre la distance du clinquant au boîtier et la taille du clinquant (c'est-à-dire le diamètre du clinquant si ce dernier est circulaire) est plus petit.

Pour la fixation et le maintien en tension (symbolisés par des traits mixtes 22) de chaque clinquant on peut utiliser par exemple des vis ou des rivets métalliques.

La forme, les dimensions et la matière d'un clinquant sont choisies en fonction de la forme de l'ouverture (évent dans l'exemple considéré) correspondante, de la distance entre le clinquant et cette ouverture, de la distance entre les circuits de haute tension et le clinquant, de l'épaisseur des parois du boîtier, des caractéristiques de la haute tension et des caractéristiques du plasma.

A titre purement indicatif et nullement limitatif, pour une ouverture circulaire de diamètre 1 mm, un boîtier ayant des parois de 1 mm d'épaisseur, une haute tension de 6 kV, un plasma de moteur ionique classique, des circuits de haute tension placés dans le boîtier à 20 mm de l'ouverture, on utilise un clinquant en cuivre, de forme circulaire, de 20 mm de diamètre, placé à 1 mm de l'ouverture, à l'extérieur du boîtier.

Dans certains cas, au lieu d'utiliser des plaques, on pourrait tout aussi bien fermer chaque ouverture 10 par une grille métallique fixée et reliée électriquement au boîtier.

La présente invention n'est pas limitée aux exemples donnés : elle est utilisable avec tout dispositif comportant des hautes tensions, au voisinage duquel sont susceptibles de se trouver des charges électriques d'un plasma ambiant ou créées artificiellement par un générateur.

## Revendications

1. Dispositif comprenant
- au moins un circuit de haute tension (6) et
- un boîtier (8) contenant ce circuit et comportant au moins une ouverture (10) qui met l'intérieur du boîtier en communication avec l'extérieur de celui-ci, des charges électriques de signe contraire à celui de la haute tension étant susceptibles d'être présentes à l'extérieur du boîtier et de pénétrer dans ce boîtier,
ce dispositif étant **caractérisé en ce qu'**il comprend en outre :
- des moyens de protection (16, 18) qui n'obturent pas l'ouverture et sont prévus pour s'opposer
- à l'entrée de ces charges à l'intérieur du boîtier, et
- à l'existence, à l'extérieur de ce dernier, de potentiels élevés dus à la haute tension du circuit.

2. Dispositif selon la revendication 1, dans lequel les moyens de protection comprennent une plaque électriquement conductrice (16, 18) fixée et reliée électriquement au boîtier, en regard de l'ouverture (10), à l'extérieur ou à l'intérieur de ce boîtier, et débordant sur la périphérie de cette ouverture.

3. Dispositif selon la revendication 1, dans lequel les moyens de protection comprennent deux plaques électriquement conductrices (16, 18) fixées et reliées électriquement au boîtier, en regard de l'ouverture (10), respectivement à l'intérieur et à l'extérieur de ce boîtier, et débordant sur la périphérie de cette ouverture.

4. Dispositif selon l'une quelconque des revendications 2 et 3, dans lequel la plaque (18), qui est située à l'intérieur du boîtier, est recouverte d'un matériau électriquement isolant (20) du côté du circuit.

5. Dispositif selon l'une quelconque des revendications 2 à 4, dans lequel chaque plaque conductrice est un clinquant (16, 18).

6. Dispositif selon la revendication 1, dans lequel les moyens de protection comprennent une grille électriquement conductrice qui est fixée et reliée électriquement au boîtier et qui ferme l'ouverture.

7. Dispositif selon l'une quelconque des revendications 1 à 6, dans lequel les charges électriques proviennent d'un plasma.

8. Dispositif selon l'une quelconque des revendications 1 à 7, dans lequel chaque circuit (6) comprend un amplificateur à tube à onde progressive.

9. Dispositif selon l'une quelconque des revendications 1 à 7, dans lequel chaque circuit est un circuit d'alimentation d'équipement embarqué comportant des tensions telles que le fonctionnement du circuit puisse être perturbé par la présence de plasma.

10. Satellite (2) comprenant au moins un moteur ionique (4) ou fonctionnant en présence de plasma naturel,
ce satellite étant **caractérisé en ce qu'**il comprend en outre au moins un dispositif (6, 8) conforme à l'une quelconque des revendications 1 à 8, les charges électriques :
- provenant du plasma (12) engendré par le moteur ionique ou du plasma naturel
- ou étant créées artificiellement par un générateur.

## Patentansprüche

1. Vorrichtung, enthaltend:
- mindestens einen Hochspannungskreis (6) und
- ein Gehäuse (8), das diesen Kreis enthält und mindestens eine Öffnung (10) aufweist, welche das Innere des Gehäuses mit seinem Äußeren verbindet, wobei elektrische Ladungen mit entgegengesetztem Vorzeichen zu dem der Hochspannung außerhalb des Gehäuses vorhanden sein und in das Gehäuse eindringen können,
wobei diese Vorrichtung **dadurch gekennzeichnet ist, dass** sie unter anderem enthält:
- Schutzvorrichtungen (16, 18), welche die Öffnung nicht verschließen und die dafür vorgesehen sind, sich zu widersetzen
- gegen das Eindringen von Ladungen in das Innere des Gehäuses; und
- gegen die Existenz hoher Potentiale aufgrund der Hochspannung des Kreises außerhalb dieses Gehäuses.

2. Vorrichtung nach Anspruch 1, bei der die Schutzvorrichtungen eine elektrisch leitende Platte (16, 18) enthalten, die am Gehäuse befestigt und mit ihm galvanisch verbunden ist, angeordnet gegenüber der Öffnung (10) außerhalb oder innerhalb des Gehäuses und über den Rand dieser Öffnung hinausragend.

3. Vorrichtung nach Anspruch 1, bei der die Schutzvorrichtungen zwei elektrisch leitende Platten (16, 18) enthalten, die am Gehäuse befestigt und mit ihm galvanisch verbunden sind, angeordnet gegenüber der Öffnung (10) außerhalb oder innerhalb des Gehäuses und über den Rand dieser Öffnung hinausragend.

4. Vorrichtung nach einem beliebigen der Ansprüche 2 oder 3, bei der die Platte (18), die im Innern des Gehäuses liegt, auf der Seite des [Hochspannungs-] Kreises von einem elektrisch isolierenden Material (20) überzogen ist.

5. Vorrichtung nach einem beliebigen der Ansprüche 2 bis 4, bei der jede leitende Platte eine Metallfolie (16, 18) ist.

6. Vorrichtung nach Anspruch 1, bei dem die Schutzvorrichtungen ein elektrisch leitendes Gitter enthalten, das am Gehäuse befestigt und mit ihm galvanisch verbunden ist und das die Öffnung verschließt.

7. Vorrichtung nach einem beliebigen der Ansprüche 1 bis 6, bei dem die elektrischen Ladungen von einem Plasma stammen.

8. Vorrichtung nach einem beliebigen der Ansprüche 1 bis 7, bei dem jeder Kreis (6) einen Wanderfeldröhrenverstärker (TWTA-Verstärker) enthält.

9. Vorrichtung nach einem beliebigen der Ansprüche 1 bis 7, bei dem jeder Kreis ein Versorgungskreis für Ausrüstung an Bord des Satelliten ist und Spannungen von der Art aufweist, dass die Funktionsweise des Kreises durch das Vorhandensein von Plasma gestört werden kann.

10. Satellit (2), der mindestens einen Ionenantrieb (4) enthält oder der in einer Umgebung mit natürlichem Plasma arbeitet,
wobei dieser Satellit **dadurch gekennzeichnet ist, dass** er unter anderem eine Vorrichtung (6, 8) gemäß einem beliebigen der Ansprüche 1 bis 8 enthält, wobei die elektrischen Ladungen:
- aus dem durch den Ionenantrieb erzeugten Plasma (12) oder aus dem natürlichen Plasma stammen;
- oder künstlich von einem Generator erzeugt werden.

## Claims

1. A device comprising:
- at least one high-voltage circuit (6), and
- a casing (8) containing the circuit and having at least one opening (10) which provides communication between the inside and the outside of the casing, electrical charges of opposite sign to that of the high voltage being likely to be present outside the casing and to enter the casing,
the device being **characterized in that** it further comprises:
- protection means (16, 18) which do not block the opening and are adapted to oppose:
-- the ingress of said charges into the casing, and
-- the existence outside the casing of high potentials due to the high voltage of the circuit.

2. A device according to claim 1, wherein the protection means comprise an electrically conductive plate (16, 18) outside or inside the casing, fixed and electrically connected to the casing, facing the opening (10) and projecting over the periphery of the opening.

3. A device according to claim 1, wherein the protection means comprise two electrically conductive plates (16, 18), respectively inside and outside the casing, fixed and electrically connected to the casing, facing the opening (10) and projecting over the periphery of the opening.

4. A device according to claim 2 or claim 3, wherein the plate (18) which is inside the casing is covered with an electrically insulative material (20) on the same side as the circuit.

5. A device according to any of claims 2 to 4, wherein each conductive plate is a foil (16, 18).

6. A device according to claim 1, wherein the protection means comprise an electrically conductive grid which is fixed and electrically connected to the casing and which closes the opening.

7. A device according to any of claims 1 to 6, wherein the electrical charges come from a plasma.

8. A device according to any of claims 1 to 7, wherein each circuit (6) comprises a traveling wave tube amplifier.

9. A device according to any of claims 1 to 7, wherein each circuit is a power supply circuit of onboard equipment and uses voltages such that operation of the circuit can be interfered with by the presence of a plasma.

10. A satellite (2) comprising at least one ion thruster (4) or operating in the presence of a natural plasma,
the satellite being **characterized in that** it further comprises at least one device (6, 8) according to any of claims 1 to 8, the electrical charges:
- coming from the plasma (12) generated by the ion thruster or from the natural plasma, or
- being created artificially by a generator.
